Europäisches Patentamt

European Patent Office

Office européen des brevets

(11) Publication number: **0 445 649 A2**

# EUROPEAN PATENT APPLICATION

(21) Application number: 91102954.4

(51) Int. Cl.⁵: **H01L 21/76**

(22) Date of filing: 27.02.91

(30) Priority: 27.02.90 JP 44630/90
17.07.90 JP 187223/90

(43) Date of publication of application:
**11.09.91 Bulletin 91/37**

(84) Designated Contracting States:
**DE FR IT**

(71) Applicant: **Oki Electric Industry Co., Ltd.**
**7-12, Toranomon 1-chome Minato-ku**
**Tokyo(JP)**

(72) Inventor: **Usui, Taiji, c/o Oki Electric Industry**
**Co., Ltd.**
**7-12, Toranomon 1-chome, Minato-ku**
**Tokyo(JP)**

(74) Representative: **Betten, Jürgen, Dipl.-Ing. et al**
**Patentanwälte Betten & Resch**
**Reichenbachstrasse 19**
**W-8000 München 5(DE)**

(54) Process for producing a semiconductor substrate having therein isolated semiconductor regions.

(57) Process for producing a semiconductor substrate having provided therein a semiconductor region(s) which is used for forming a semiconductor device. In the first way, a semiconductor substrate body (104) is formed by attaching a first substrate (100) to a second one (102). The body is subjected to etching treatments to form deep and shallow grooves (120, 122) reaching inside of the second substrate (102) and the same depth from the interface between the first and second substrates. A semiconductor layer (136; 402) is formed on the uneven surface of the grooved body (124) with an isolation layer(s) (132; 132 and 400) interposed therebetween by using a method of reduction with hydrogen or by that of dropping molten semiconductor material. Subsequently, the exposed principal surface of the second substrate (102) is polished to a depth reaching bottoms of the grooves (120, 122), thereby forming deep and shallow isolated-islands (144, 146) as semiconductor regions. In the second way, a semiconductor substrate body (304) formed of a substrate (300) and an epitaxial layer (302) formed thereon is used. After a recess(es) is formed in the substrate (300) using the first mask, deep and shallow grooves (324, 326) similar to those (120, 122) in the first way are formed in the body (304) while using the second and third masks (320, 322) formed on thick and thin substrate layers (310, 312),

respectively. After removal of the whole third mask (322) and of part of the second mask (320) in its thickness direction, a semiconductor layer(s) (340) is formed with molten semiconductor material of poor wettability on the residual second mask portion(s) (306). Next, the exposed surface of the grooved epitaxial layer (336) is polished thereby forming a semiconductor region(s) (300) and deep and shallow isolated-islands (370, 372). In the third way, a recess(es) (206) is formed in a substrate (200) using a mask (204). Subsequently, a semiconductor layer is formed in the recess(es) (206) using a method of dropping semiconductor material of poor wettability on the mask (204) and then polished to form a semiconductor region(s) (212).

*FIG.3* I

## FIG.3 A

## FIG.3 L

The present invention relates to a process for producing a semiconductor substrate, and more particularly to a process for producing a semiconductor substrate having provided therein semiconductor regions which are used for forming a semiconductor device.

An insulation film isolation (also called dielectric isolation) technique(s) and a PN junction isolation technique(s) are now known as techniques for forming electrically isolated device regions in semiconductor substrates.

A PN junction isolation technique is disclosed in the literature, for example, "Proceedings of 1988 International Symposium on Power Semiconductor Devices, Tokyo, 1988, pp 88 - 95". According to the technique, different conductive type semiconductor regions are formed in one and same semiconductor substrate.

Furthermore, it is well known to form island-like semiconductor regions in one and the same semiconductor substrate by using a diffusion technique, one conventional example of which be briefly mentioned hereinafter with reference to Figs. 1A - 1C.

First, as shown in Fig. 1A, a $SiO_2$ film is formed on, for example, one of the main or principal surfaces of an N-type semiconductor substrate 10, and then a mask pattern(s) 14 having an opening(s) 12 with a desired configuration is formed by using a photolithographic etching technology.

Then, as shown in Fig. 1B, a P-type impurity containing region(s) 16 is formed in the semiconductor substrate 10 by ion-implanting p-type impurity thereinto through the opening(s) 12.

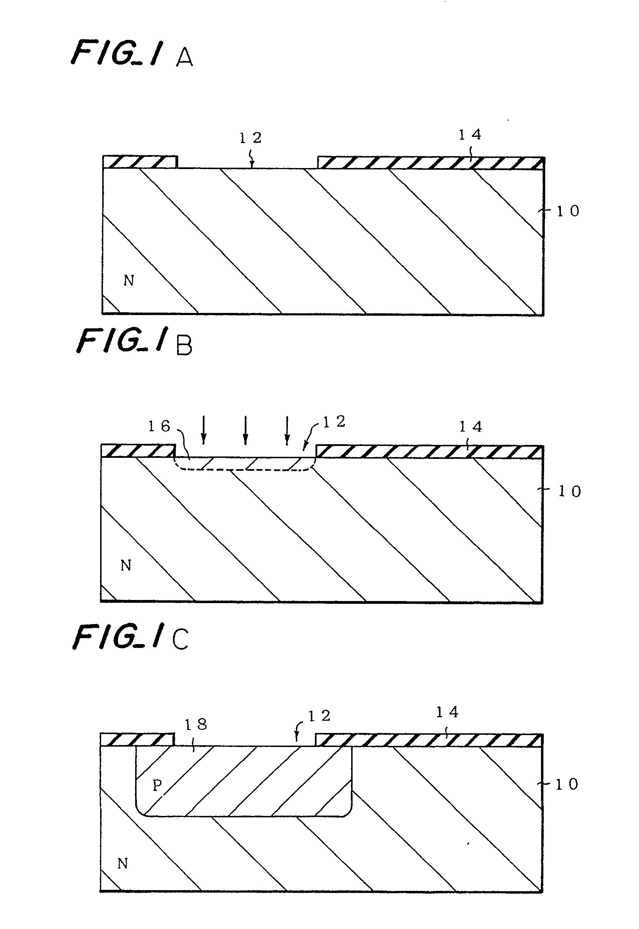

After this, by annealing the substrate 10, the P-type impurity in the P-type impurity containing region(s) 16 are diffused into a surrounding region(s) in the substrate 10, thereby obtaining a P-type semiconductor region(s) 18 as shown in Fig. 1C.

Accordingly, a semiconductor device with different conductive type regions in one and the same semiconductor substrate 10 is produced.

This production process is commonly used to form, for example, a P-well region(s) in MOS devices, or a P-type isolation region(s) in an N-type epitaxial layer(s) of bipolar devices.

Also known are intelligent power devices, in which one or more power devices of large current type or high voltage type, and logic devices of low current and low voltage type for controlling the power devices are formed in a single micro-chip.

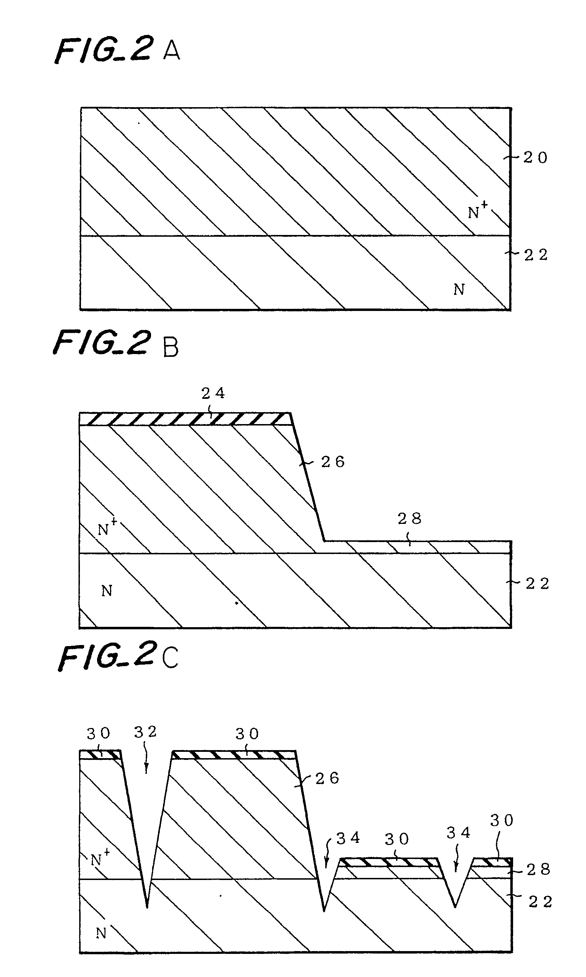

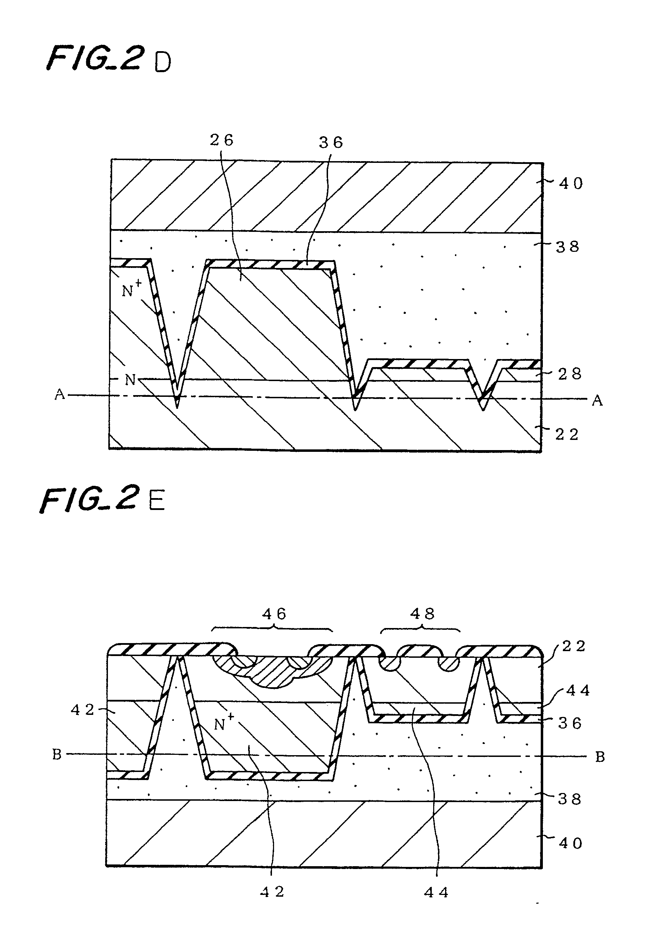

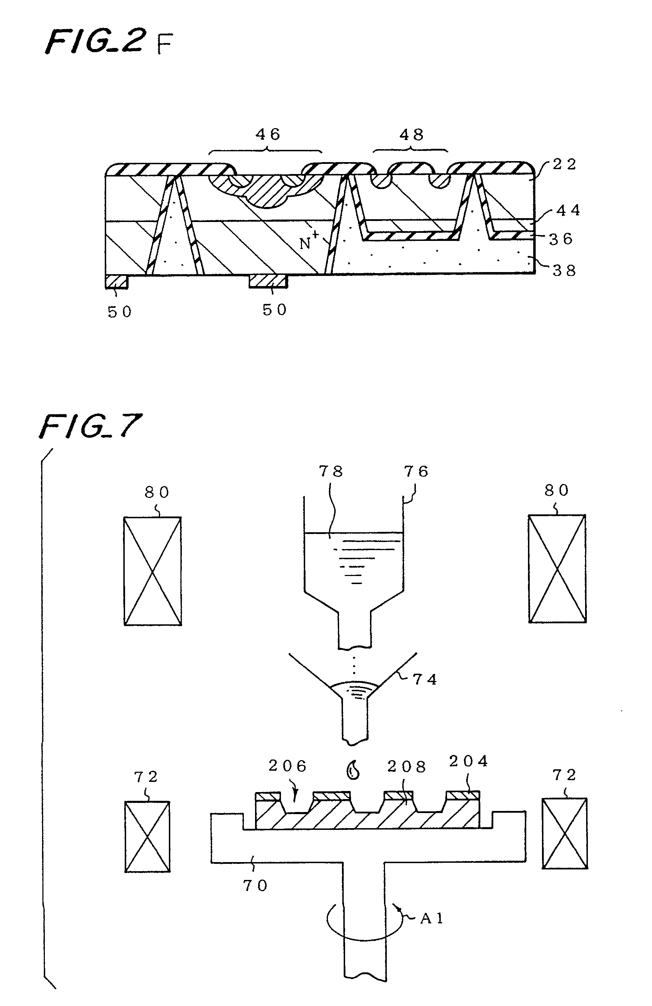

The process for producing the semiconductor substrate used for forming therein the intelligent power device is explained with reference to Figs. 2A through 2F.

The process is disclosed in a Japanese Utility Model Appln. No. 01-098503 filed by the present applicant.

An $N^+$ semiconductor substrate 20 having a thickness approximately 500 $\mu$m, containing N-type impurities at high concentration, and having surface crystal orientation of (100). First, an N-type epitaxial layer 22 is formed to a thickness of approximately 30 $\mu$m on the (100) principal surface of the substrate 20 thereby obtaining such a structure as shown in Fig. 2A.

Next, a first insulation film is formed on the opposite side principal surface of the $N^+$ semiconductor 20. Subsequently, the first insulation film is removed at its part on a predetermined region(s) for a shallow isolation island(s), which is described hereinafter in more detail, by an ordinary photolithographic treatment to form an insulation film pattern(s) 24. Then, using this insulation film pattern 24 as a mask, part of the $N^+$ semiconductor substrate 20 is removed by etching with an etching solution of alkaline type. The resultant structure is shown in Fig. 2B.

In this etching, it is desirable to leave a portion of $N^+$ semiconductor substrate on the side of the N-type epitaxial layer 22 as an $N^+$ buried layer (a layer shown by 28 in Fig. 2D). The residual portion has a thickness of about 5 to 10 $\mu$m. In Fig. 2B, a remaining or residual thick substrate portion beneath the mask 24 is shown by a numeral 26, and the remaining or residual thin substrate portion as a result of etching is shown by a numeral 28.

Next, after removing the mask, that is, the remaining first insulation film portion 24 with a diluted HF solution, a second insulation film is formed on the surface of the residual $N^+$ semiconductor substrate portions 26 and 28. Then, the second insulaiton film is subjected to photorithographic etching treatment of form a predetermined mask pattern 30 comprising the second insulation film portion.

Subsequently, using the second mask pattern 30, the $N^+$ semiconductor substrate portions 26 and 28 and the N-type epitaxial layer 22 are etched with an alkaline-type etching solution. By this etching, deep V-shaped grooves 32 are formed in the thicker substrate portion 26 and shallow V-shaped grooves 34 are formed in the thinner substrate part 28. The resultant structure is shown in Fig. 2C.

Then, after removing the mask pattern 30 by etching with a diluted HF solution, an isolation film 36 is formed on the whole surface of the structure including the deep V-shaped grooves 32 and the shallow V-shaped grooves 34. The isolation film 36 is covered with a glass layer 38, comprising Si-B-O type glass particles.

Thereafter, a supporting semiconductor substrate 40 is provided on the glass layer 38 and a structure thus obtained is sintered in a electric furnace at approximately 1200 °C. As a result of this, the $N^+$ semiconductor substrate portions 26 and 28 are bounded to the supporting semiconductor substrate 40 with the sintered glass layer 38 interposed therebetween. The resultant structure is shown in Fig. 2D.

Then, the N-type epitaxial layer 22 is polished or ground away from the exposed surface side up to a level indicated by the line A-A in Fig. 2D, where the tips of the deep V-shaped grooves 32 and the shallow V-shaped grooves are exposed.

Thus, a plurality of deep isolated or electrically separated islands 42 and shallow isolated or electrically separated islands 44 are formed as shown in Fig. 2E.

Next, by using a well known technology, power devices 46 of large current type or high voltage type are formed on the deep isolated islands 42, and logic devices 48 of low voltage type on the shallow isolated islands 44, respectively. The resultant structure is shown in Fig. 2E.

BY the way, Fig. 2E shows a structure obtained by polishing the structure shown in Fig. 2D and turning upside down so that the supporting semiconductor substrate 40 is on the lower side of the structure.

Subsequently, the supporting semiconductor substrate 40, the glass layer 38, and the thick $N^+$ semiconductor substrate portions 26 are removed by polishing or grinding up to the B-B line so that the thick substrate portions 26 of the deep isolated islands 42 will be exposed.

Thereafter, the rear side electrode metals 50 are formed on the B-B ground surface of the deep isolated islands 26, thereby obtaining an intelligent power device (Fig. 2F).

However, according to the conventional production process as explained referring to Fig. 1, it takes a longer time for heat treatment in order to form the P-type region(s) 18 in the N-type substrate 10 down to the deep depth after the above-mentioned ion implantation. For example, it took up to 60 hours to form a P-type semiconductor region down to a depth of 30 $\mu$m in an N-type (100) substrate with a resistivity of 20 $\Omega \cdot cm$.

Moreover, this heat treatment causes the P-type impurities in the layer 16 to diffuse not only in the depth direction of the semiconductor substrate 10, but also in the lateral direction thereof. The diffusion length in the lateral direction reaches as much as 80 % of that in the depth direction.

The P-type semiconductor region formed by this lateral diffusion works as a non-effective or idle region when, for example, it is used as an isolation region in an N-type epitaxial layer for a bipolar device. The non-effective region causes great reduction of the integration density.

As described above, according to the conventional production process, when forming different conductive type regions deep in a semiconductor substrate, a long heat treatment period is required and therefore the non-effective region is enlarged to result in reduction of the integration density.

On the other hand, one application of the conventional technique is disclosed in "Integrated Circuits for the Control of High Power," p 408-413, IEDM '83, which states that the technique can be applied to a method of isolating a power section from a logic section in a SMART POWER DEVICE. However, this method has such problems that it not only requires a long epitaxial growth time to be repeated twice for P-type and N-type epitaxies on an $N^+$ substrate, but also requires a long $N^+$ diffusion time to connect the $N^+$ substrate with the N-type epitaxial region or a long isolation diffusion time for the N-type epitaxial region.

In addition, in the production process explained above reference to Figs. 2A through 2F, the removal of the $N^+$ semiconductor substrate 20 and the formation of the deep V-shaped grooves 32 and shallow V-shaped grooves 34 (see Fig. 2B and Fig. 2C) causes mechanical strength of the $N^+$ semiconductor substrate 20 to lower, resulting in the damage of the substrate in subsequent production steps. Thus technically satisfactory semiconductor substrates are not obtained.

It may be initially possible to form a sufficiently thick N-type epitaxial layer 22 so as to increase its mechanical strength. However, in that case, there occurs such problems as not only requiring a long time to form the $N^+$ epitaxial layer 22 but also being incapable of producing an N-type epitaxial layer 22 with high resistivity because of the auto-doping of N-type impurities from the $N^+$ semiconductor substrate 20 into the epitaxial layer 22.

Accordingly, one object of the present invention is to provide a process for manufacturing semiconductor substrate, in which intermediate substrate structures formed in the respective steps of the process are not broken and or damaged.

Other object of the present invention is to provide a process for manufacturing a semiconductor substrate, in which the thermal diffusion time is greatly reduced, to thereby make possible to form a semiconductor region(s) used for forming devices at a high-integration density in a semiconductor substrate.

Still other object of the present invention is to provide a process for manufacturing a semiconductor substrate, in which a semiconductor region(s) can be formed in the semiconductor substrate by using a reduced number of epitaxial depositions and a shorter isolation diffusion time.

In accordance with one aspect of the present invention, the above-mentioned first object is achieved by providing a process for producing a semiconductor substrate comprising the steps of:

(a) forming a semiconductor substrate body by attaching a first semiconductor substrate to a second semiconductor substrate;

(b) forming the first mask pattern(s) on the principal surface of the first semiconductor substrate;

(c) carrying out a first etching treatment of an exposed principal surface region(s) of the first semiconductor substrate from the side of the first mask pattern(s) down to a depth reaching part in a thickness direction of the first semiconductor substrate;

(d) removing the first mask pattern(s);

(e) forming the second mask pattern(s) on exposed surface of each of thick and thin substrate layers which are regions of the first semiconductor substrate remained after the first etching treatment;

(f) carrying out a second etching treatment of exposed regions of the thick and thin substrate layers, from the side of the second mask pattern(s) to form grooves reaching inside the second semiconductor substrate, the grooves having their bottoms at an identical depth from an attaching interface of the first and second semiconductor substrates;

(g) forming, after the removal of the second mask pattern, an isolation film on the entire surface of the grooved side of the semiconductor substrate body;

(h) forming a semiconductor layer by filling a recess(es) of a structure obtained after the formation of the isolation film with semiconductor material;

(i) polishing the second semiconductor substrate from the exposed principal surface thereof to a depth reaching the bottom of the grooves; and

(j) polishing a structure obtained after the formation of the semiconductor layer from the surface side thereof to a depth reaching midway in the thickness direction of the thick substrate layer(s), but not reaching the isolation film on the thin substrate layer(s), thereby obtaining deep and shallow isolated-islands as semiconductor regions.

According to this first process, a plurality of isolated islands with different thicknesses that act as semiconductor regions can be formed in a semiconductor body consisting of a first semiconductor substrate and a second semiconductor substrate bonded together. Therefore, by making the second semiconductor substrate thicker, the mechanical strength of the semiconductor substrate body can be increase, thereby eliminating the possibility of intermediate substrate structure getting damaged and or broken during the manufacturing process.

In addition, according to the above-mentioned process, because the second semiconductor substrate is not formed by means of epitaxial growth, it is substantially free from the auto-doping phenomenon between the first semiconductor substrate and the second semiconductor substrate, and hence the second semiconductor substrate can be maintained at the required high resistivity.

In accordance with other aspect of the present invention, the above-mentioned second objective is achieved by providing a process for producing a semiconductor substrate comprising the steps of:

(a) forming a mask pattern(s) consisting of insulation film(s) on one of the principal surfaces of a semiconductor substrate;

(b) forming a recess(es) by carrying out an etching treatment of principal surface portions of the semiconductor substrate uncovered with the mask pattern(s);

(c) forming a semiconductor layer(s) in the recess(es) by dropping molten semiconductor material containing impurity and with poor wettability to the mask pattern(s) onto the surface, on the side of the mask pattern(s), of a structure obtained in the step (b); and

(d) polishing a structure obtained in the step (c) from its surface on the side of semiconductor layer(s) so as to form a flat surface consisting of the surface of the insulation film(s) and that of the semiconductor layer(s) to thereby obtain a semiconductor region(s) with residual part of the semiconductors layer(s).

According to this second process, because the semiconductor regions are formed by dropping molten semiconductor material containing impurity onto an uneven surface of the semiconductor substrate, no special impurity diffusion treatment and thus no special long-time heat treatment for the impurity diffusion treatment is required. When using the semiconductor regions as isolation regions, a semiconductor substrate suitable for high integration can be obtained because of less reduction of active regions used for forming devices.

In accordance with still other aspects of the present invention, the above-mentioned third objective is achieved by providing a process for producing a semiconductor substrate comprising the steps of:

(a) forming a semiconductor substrate body by means of growing an epitaxial layer on one of the principal surfaces of a semiconductor substrate;

(b) forming the first mask pattern(s) of the other principal surface of the semiconductor substrate:

(c) carrying out a first etching treatment of an exposed region(s) of the other principal surface of the semiconductor substrate from the side of the first mask pattern(s) down to a depth reaching part of the thickness of the semiconductor substrate;

(d) forming the second mask pattern(s) on a thick semiconductor layer(s) by utilizing the first mask pattern(s) and the third mask pattern(s) thinner than the second mask pattern(s) on a thin substrate layer(s), the thick and thin substrate layers being regions of the semiconductor substrate remained after the first etching treatment;

(e) carrying out a second etching treatment of exposed regions of the thick and thin substrate layers from the side of the second and third mask patterns to form grooves reaching inside the epitaxial layer, the grooves having their bottoms at an identical depth from the interface of the semiconductor substrate and the epitaxial layer;

(f) removing the third mask pattern(s);

(g) forming, after the removal of the third mask pattern(s), a semiconductor layer(s) having a flat surface by filling a recess(es) of a structure obtained after removal of the third mask pattern(s) with molten semiconductor material having poor wettability on the first mask pattern(s) and containing impurity;

(h) polishing the epitaxial layer from exposed principal surface thereof to a depth reaching the bottom of the grooves; and

(i) polishing the semiconductor layer(s) from the surface side thereof to a depth reaching midway in the thickness direction of the thick substrate layer(s), but not reaching the thin substrate layer(s) to thereby obtain a semiconductor region(s) with residual part of the semiconductor layer(s).

According to this third process, the epitaxial growth treatment may be performed only once on the first semiconductor substrate so as to form the semiconductor substrate body. And, because semiconductor regions are formed in the semiconductor substrate body by means of dropping of molten semiconductor material thereonto, no special isolation diffusion is required when these regions are used as isolation regions.

Figs. 1A to 1C are process diagrams illustrating a conventional process for producing a semiconductor substrate in which different semiconductor regions are formed in one semiconductor substrate by using the diffusion method;

Figs. 2A to 2F are process diagrams for explaining a conventional process for producing a semiconductor substrate used for intelligent power devices;

Figs. 3A to 3N are process diagrams for explaining one example of a process for producing a semiconductor substrate of the present invention, the substrate having provided therein a plurality of island-like semiconductor regions each of which is separated by an insulation film;

Figs. 4A to 4D are process diagrams for explaining other example of a process for producing a semiconductor substrate of the present invention, in which a plurality of island-like semiconductor regions are formed in the semiconductor substrate using a technique of dropping molten semiconductor material thereon;

Figs. 5A to 5I are process diagrams for explaining still other example of a process for producing a semiconductor substrate of the present invention, the semiconductor substrates having provided therein a plurality of island-like semiconductor regions separated from each other by means of the PN junction separation method, and formed by using a technique of dropping molten semiconductor material on the substrate;

Figs. 6A to 6C are process diagrams for explaining a process for producing a semiconductor substrate of the present invention having provided therein a plurality of island-like semiconductor regions separated from each other by insulation films, the process using a technique of dropping molten semiconductor material; and

Fig. 7 is a diagram for explaining the technique of dropping molten semiconductor material, which is used for carrying out examples of the present invention.

Examples of a process for producing a semiconductor substrate having provided therein a plurality of island-like semiconductor regions of the present invention will be described while referring to the accompanying drawings.

In the figures, the shapes and sizes of constituents as well as the positional relationships therebetween are drawn so schematically as to merely facilitate the understanding of the present invention. The following examples are merely suitable cases, and hence should not be construed as limiting the scope of the present invention.

FIRST EMBODIMENT

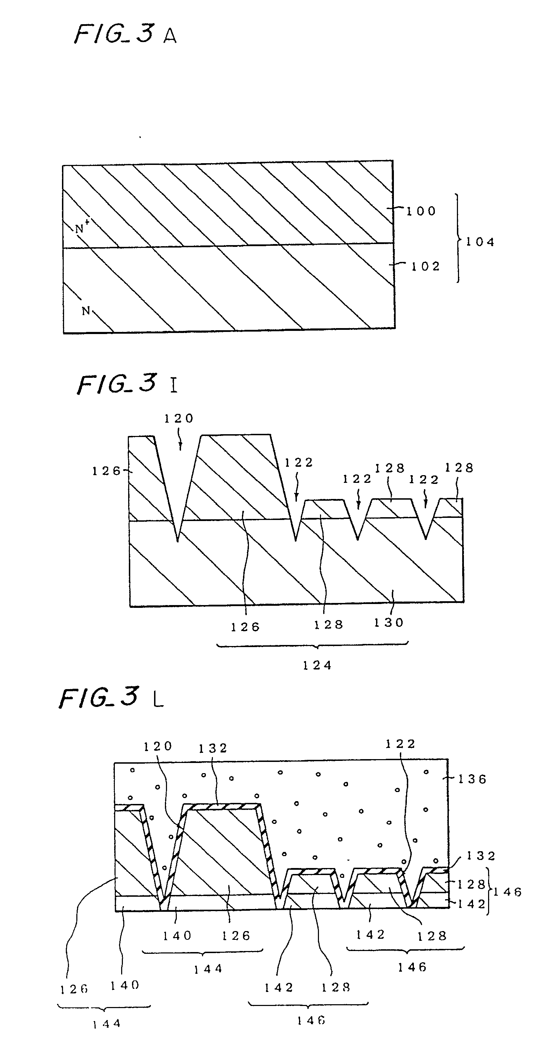

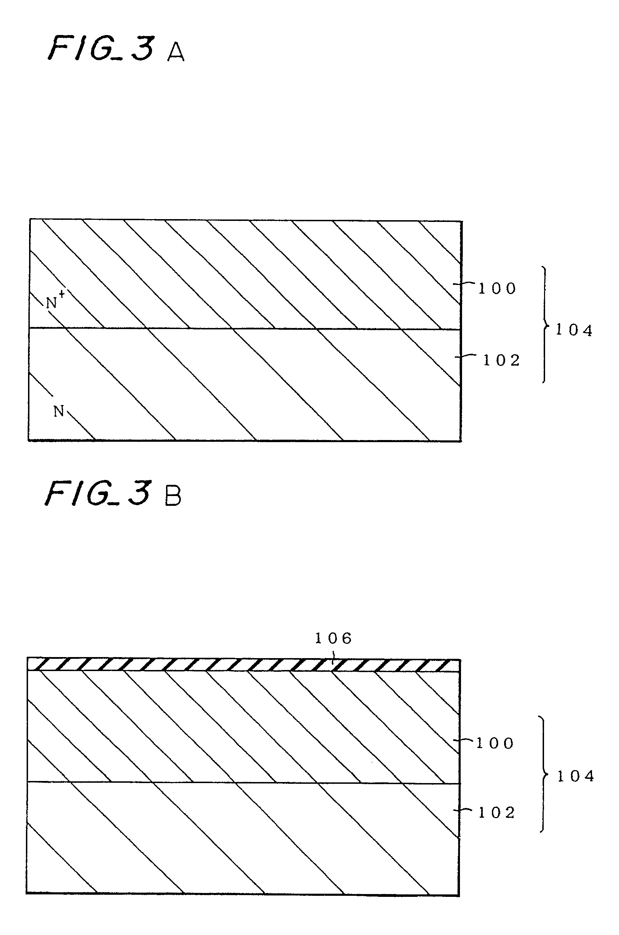

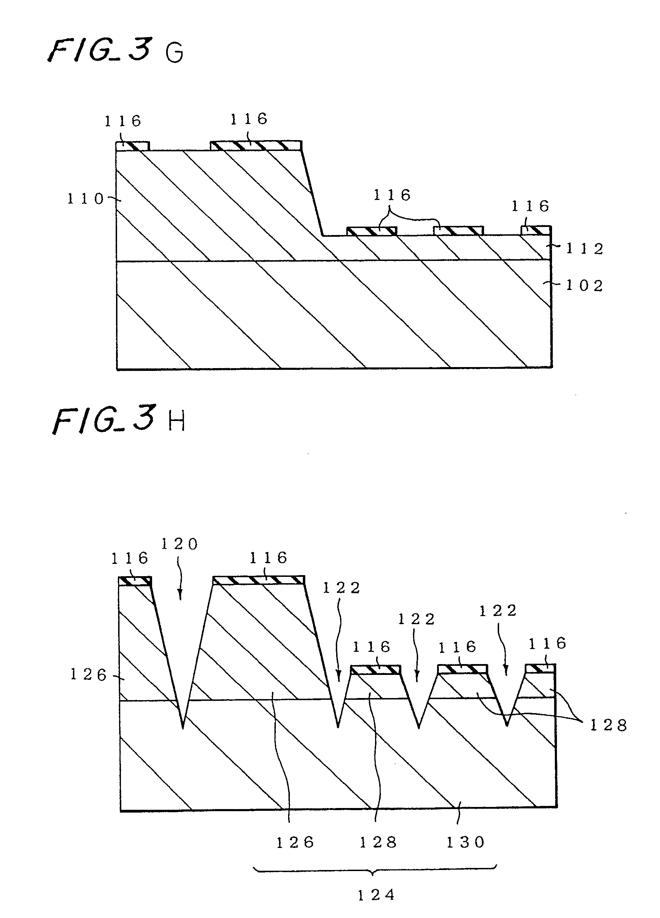

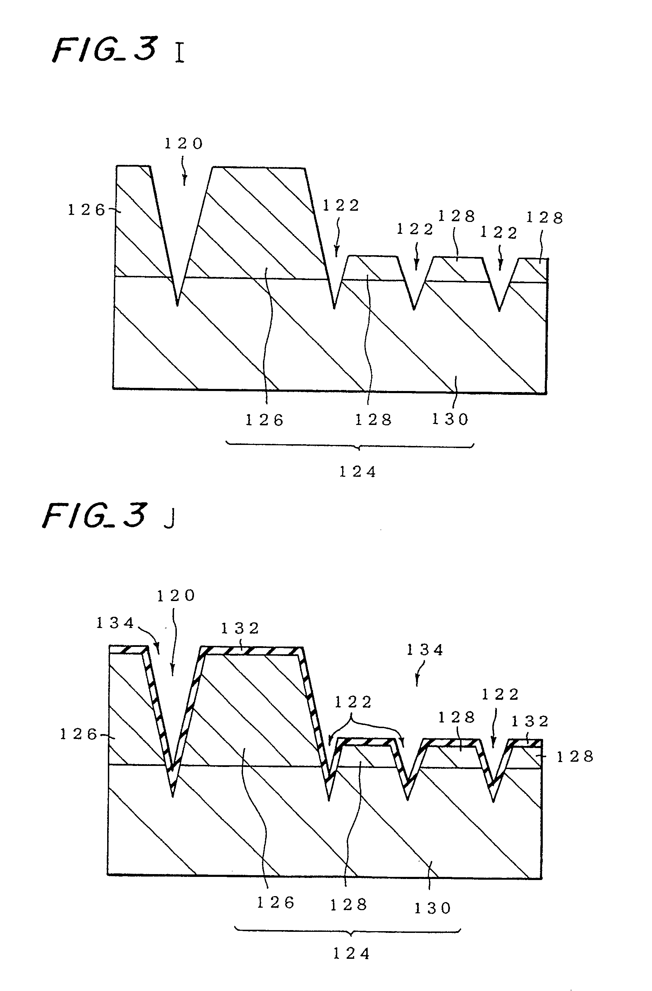

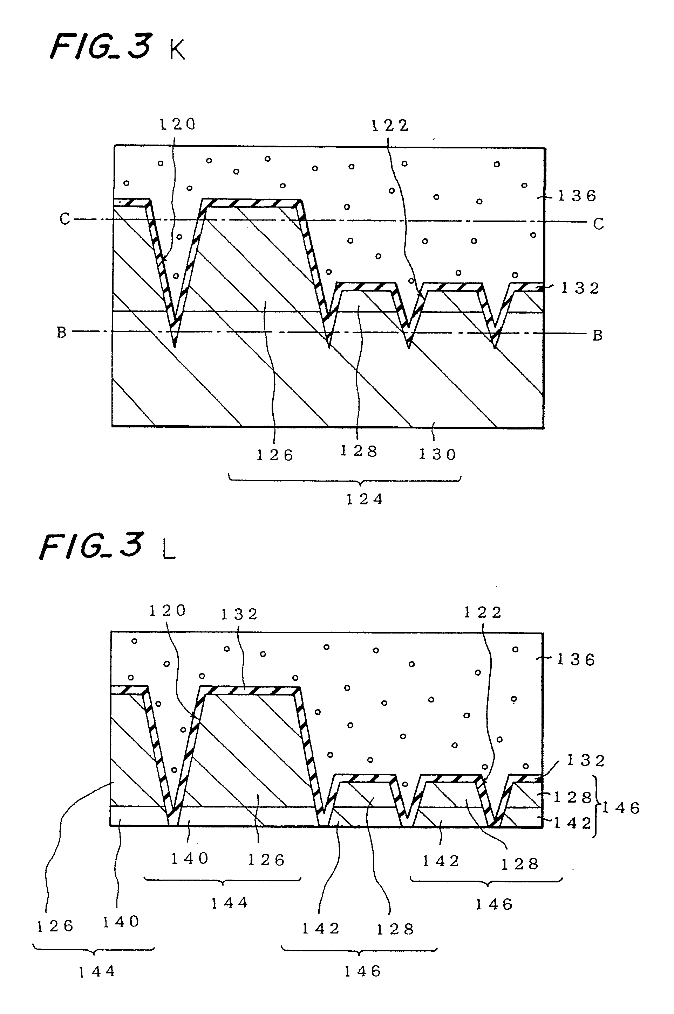

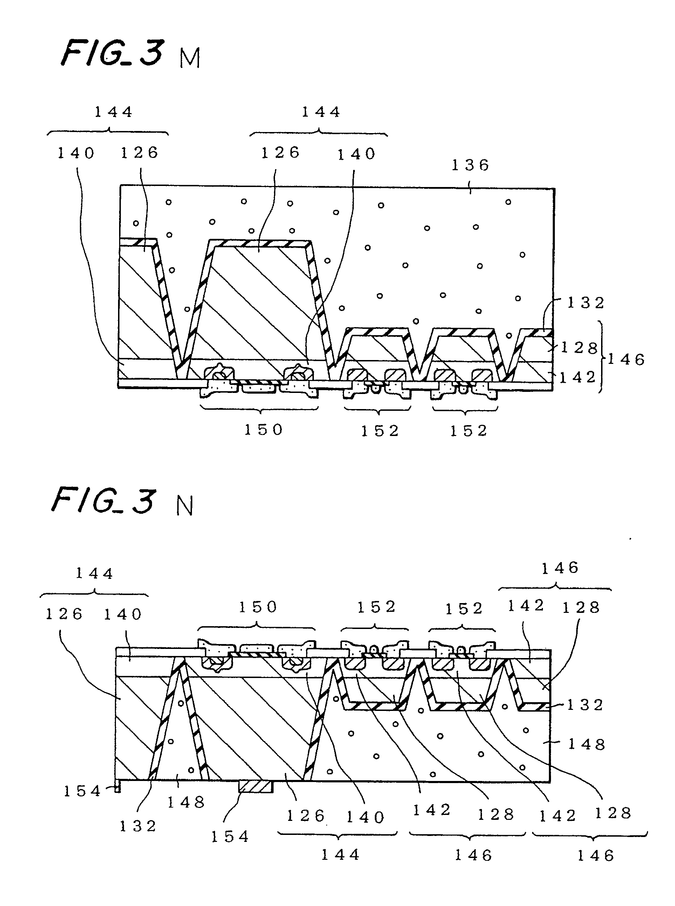

The first embodiment of the present invention will be described with reference to Figs. 3A to 3N.

The first semiconductor substrate 100 is made of an N-type Si semiconductor substrate having an approximately 500 $\mu$m thickness and with a resistivity or a specific resistance of approximately 0.01 $\Omega$ $\cdot$ cm. A second semiconductor substrate 102 is made of an N type Si semiconductor with a resistivity of approximately 3 $\Omega$ $\cdot$ cm. After both substrates 100 and 102 are hydrophilically treated in, for example, HF aqueous solution, the principal or main surfaces of the substrates are affixed or luminated together using a direct silicon bonding technology according to which both Si wafer substrates 100 and 102 are directly bonded or attached to thereby obtain a semiconductor substrate body 104 (Fig. 3A).

Considering subsequent steps of the process, it is desirable that the N-type semiconductor substrate 102 have a thickness of at least 100 $\mu$m so as to prevent it from breaking and/or occurring damages in the subsequent steps.

Then the first insulation film 106 is formed on the other, or exposed, principal surface of the $N^+$ semiconductor substrate 100 (Fig. 3B). The insulation film 106 is partially etched away according to an ordinary patterning technology to form a first mask pattern 108 (Fig. 3C). In this formation, an insulation film portion(s) is left on a principal surface region(s) of the first semiconductor substrate 100 which is destined to form, for example, a deep isolation island(s) and an insulation film portion(s) on a region(s) destined to form a shallow isolation island(s) is removed by the etching treatment. In Fig. 3C, the exposed principal surface portion of the first semiconductor substrate 100 is shown by a reference numeral 100a.

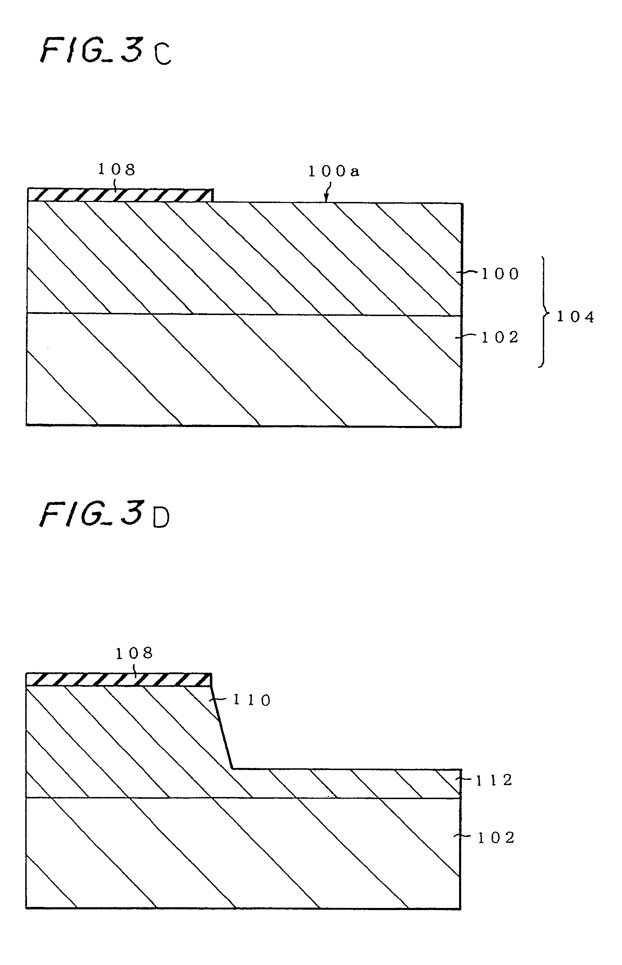

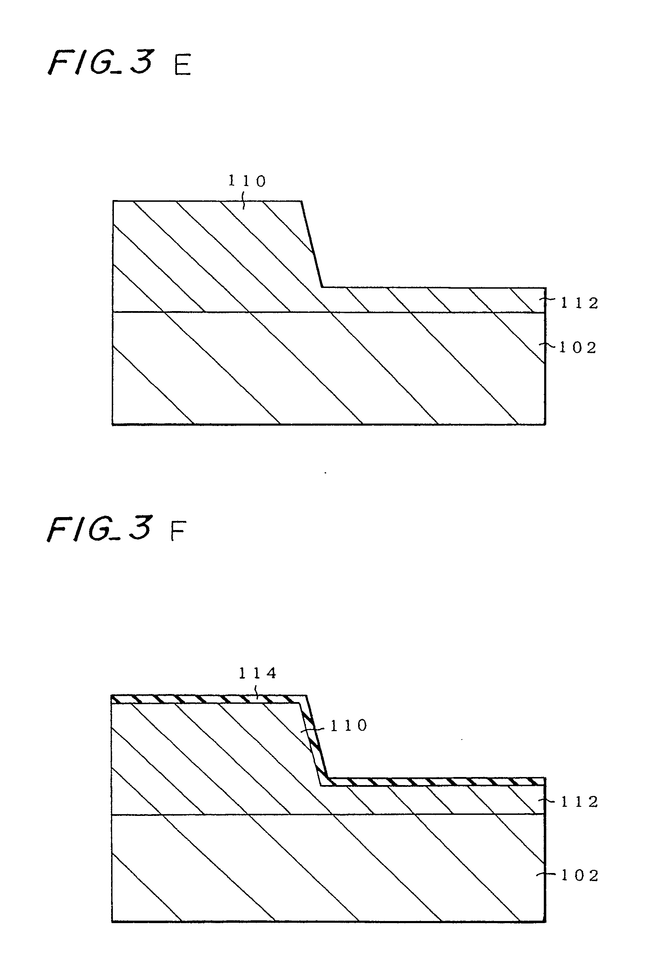

Next, the exposed surface portion 100a of the $N^+$ semiconductor substrate 100 is subjected to a first etching treatment using the first mask pattern 108 as a mask. This first etching treatment is performed using an alkaline type etching solution to thereby remove a portion(s) of the first semiconductor substrate from the surface thereof down to a depth of, for example, about 400 $\mu$m. A resultant structure as shown in Fig. 3D is thus obtained.

In this removing step, a portion(s) of the $N^+$ semiconductor substrate 100 adjacent to the N-type epitaxial layer 102 is preferably left as a layer(s) of approximately 5 to 10 $\mu$m thickness. The layer(s) will act as an $N^+$ buried layer(s) in a semiconductor substrate of the invention. In Fig. 3D, the portion of the substrate 100 that remains thick as a result of the first etching is shown by a reference numeral 110, and the portion of the substrate 100 that remains thin is shown by a reference numeral 112. These portions 110 and 112 are also called as a thick substrate portion or layer and a thin substrate portion or layer, respectively.

Next, after removing the first mask pattern 108 (see Fig. 3E), a second insulation film 114 is formed on the surface of the thick substrate layer 110 and the thin substrate layer 112 (see Fig. 3E).

Then, using a photolithographic etching technology, the second insulation film 114 is shaped to a predetermined pattern to form a second mask pattern 116 (see Fig. 3G).

The first and second insulation films described above may be formed by $SiO_2$ films or another type of insulation films. These insulation films may be subjected to any suitable etching method according to the designing.

Subsequently, using this second mask pattern 116 as a mask, the remaining thick and thin substrate layers 110 and 112 are subjected to the second etching treatment. In this second etching, the remaining layers 110 and 112 of the $N^+$ semiconductor substrate as well as the N-type semiconductor substrate 102 are partially etched with an alkaline type etching solution, thereby forming a deep V-shaped groove(s) 120 and a shallow V-shaped groove(s) 122. The bottom parts of these grooves 120 and 122 are at a level of an identical depth from the bonding interface at which the first and second semiconductor substrate are bonded. A resultant structure is shown in Fig. 3H.

In Fig. 3H, a semiconductor body portion that remains as a result of the etching, i.e. a semiconductor body with grooves, is shown by a reference numeral 124. Such a semiconductor body 124 is also called as a grooved semiconductor body. The island-like region(s) as a remaining portion of the thick substrate layer is shown by a reference numeral 126, the island-like region(s) that remain as a portion(s) of the thin substrate layer is shown by a reference numeral 128, and the second semiconductor substrate having formed therein portions of the grooves is shown by a reference numeral 130. The substrate 130 is also called as a grooved substrate.

Then, the second mask pattern 116 is etched away with a diluted HF solution (see Fig. 3I). After that, an isolation or insulation film 132 is formed by deposition on the upper surface of the grooved body 124 including the deep V-shaped grooves 120 and the shallow V-shaped grooves 122, which results in obtaining a structure as shown in Fig. 3J.

The insulation film 132 is so thin that grooves after provided thereon with the insulation film 132 can still remain as V-shaped grooves, and hence are shown by the same reference numerals 120 and 122.

Subsequently, a recess(es) or a concave portion(s) including these grooves 120 and 122 and other lower portions of the structure with the isolation film 132 are filled with semiconductor material suitable for forming a semiconductor layer 136 (Fig. 3K). In Fig. 3J, the recess(es) is shown by a reference numeral 134. In this example, the semiconductor material may be polycrystalline Si. Therefore, in this embodiment, the polycrystalline Si layer 136 serving as a supporting layer is first grown on the structure by reducing $SiH_2Cl_2$ with hydrogen. The thickness of the grown layer 136 is about 500 $\mu$m. After that, the top surface of this polycrystalline Si layer 136 is subjected to the planarization treatment.

Then, the second semiconductor substrate 130 is polished or ground from the exposed principal surface to the bottom of the grooves 120 and 122. This polishing or grinding is carried out up to a level indicated by the B-B line in Fig. 3K thereby obtaining a structure as shown in Fig. 3L. In Fig.

3L, portions beneath the island-like regions 126 in the remaining region of the second semiconductor substrate 130 are shown by a reference numeral 140, and portions beneath the island-like regions 128 are shown by a reference numeral 142.

Thus, a plurality of deep islands 144 and shallow islands 146 having therein the island-like regions 126 and 128 as N$^+$ buried layers, respectively, are formed (Fig. 3L). The deep islands 144 are isolated or electrically separated from each other and the shallow islands 146 are also isolated or electrically separated from each other. Accordingly, the deep islands 144 and shallow islands 146 are called as deep isolated-islands 144 and shallow isolated-islands 146, respectively. These islands 144 and 146 serve as semiconductor regions used for forming a semiconductor device.

Next, using a well known technique, power devices 150 are formed in the deep isolated-islands 144 and logic devices 152 are formed in the shallow isolated-islands 146, thereby obtaining a structure as shown in Fig. 3M.

Then, the polycrystalline Si layer 136 is polished or ground to the C-C line (see Fig. 3K) to expose a substrate portion(s) of the N$^+$ semiconductor material in the deep isolated islands 144. By this polishing, a flat or plane surface is formed, and the remaining polycrystalline Si layer regions serve as a supporting layer 148. Further, this polishing is done from the planarized surface of the poly-Si layer 136 down to a midway in the thickness direction of the thick substrate layers (island-like regions 126), and not reaching the insulation film 132 on the thin substrate layers (island-like regions 128).

Then, after forming a metal film such for example, as a chrome-nickel-gold (Cr-Ni-Au) film on the polished surface formed at the above-mentioned C-C line, portions of the metal film other than those on the substrate portions 126 of the N$^+$ semiconductor material are etched away, thereby forming a rear side electrode(s) 154 by the remaining metal film portion(s). Thus, an intelligent power device is completed with a structure such as shown by Fig. 3N.

In this first embodiment, while the explanation was limited to the conduction type of the N$^+$ semiconductor substrate 100 and N-type semiconductor substrate 102 and their resistivity, it is a matter of course that the structure can be applied to substrates of different conduction type and/or resistivity.

SECOND EMBODIMENT

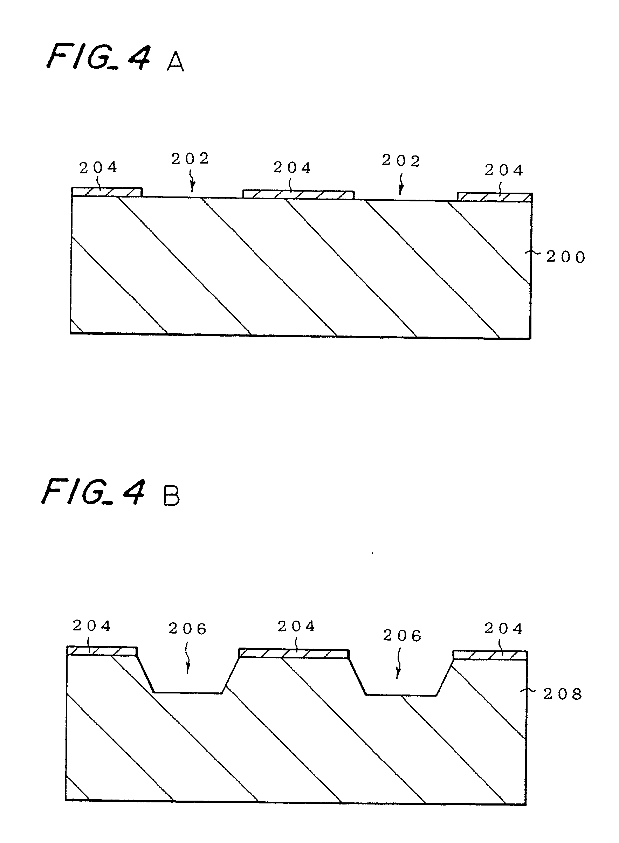

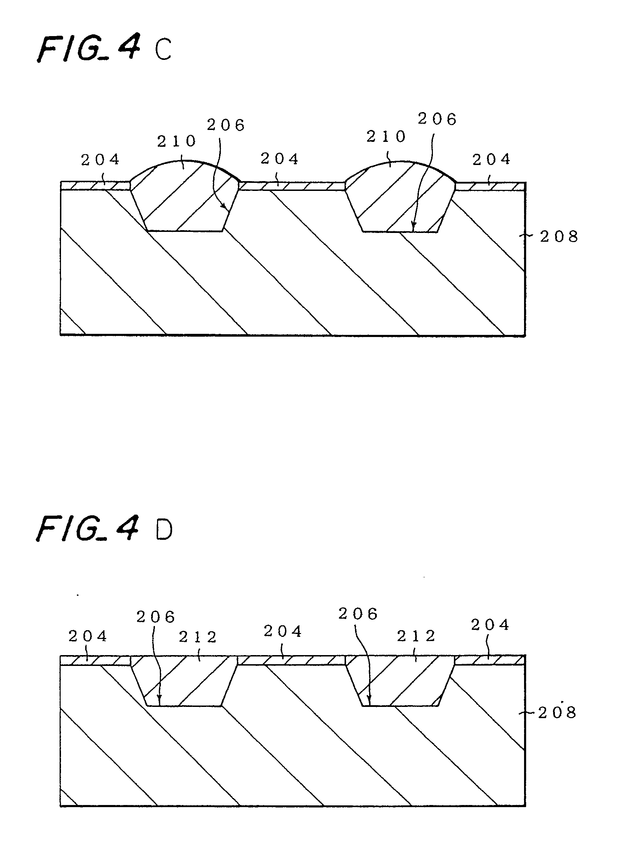

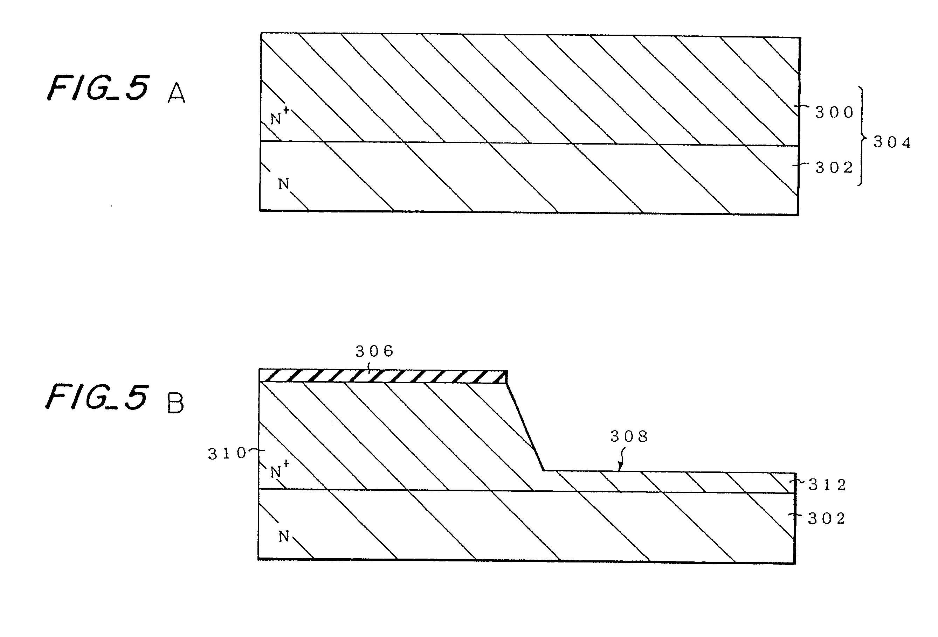

The second embodiment of the present invention will be described with reference to Figs. 4A to 4D. Figs. 4A to 4D are diagrams, each showing in cross-section a structure obtained by each of steps according to the production process of the present invention.

First, a SiO$_2$ film is formed as an insulation film on one of the principal surfaces of the first conduction type Si semiconductor substrate 200. The principal surface has a crystal surface orientation of (100). Then an opening(s) 202 is formed in a desired configuration by means of a photorithographic etching technology to form a mask pattern(s) 204 (Fig. 4A). Meanwhile, the SiO$_2$ film can be formed by thermally oxidizing the Si substrate, by means of the CVD method, or the like.

An exposed principal surface portion(s) is then etched by an alkaline anisotropic etching process while using the mask patterns 204 of the SiO$_2$ film to thereby form a recess(es) or a concave portion(s) 206 in the substrate 200, resulting in obtaining a substrate having formed therein a recess(es) 206. The substrate with the recess(es) 206 is shown by a reference numeral 208 and called as a recessed substrate (Fig. 4B).

In this step, when a mixture of solutions of KOH-IPA-H$_2$O (here, "IPA" is isopropyl alcohol) is used as an alkaline etching solution. When using the warmed solution heated to a temperature in a range of 70 °C to 80 °C, the shape of the recess(es) 206 can be preserved and the occurrence of micro-pyramids can be suppressed.

The depth and size of the recess 206 can be controlled by the size of the openings 202 of the mask and by the duration of the alkaline anisotropic etching treatment. Therefore, the desired depth and size can be easily obtained.

In this second embodiment, the shape, in cross-section, of the recess(es) concave portion(s) 206 is trapezoidal, but it can also be a V-shaped groove(s).

Next, semiconductor layers 210 are formed in the recesses 206 of the substrate 208 from the side of the mask pattern 204, thus obtaining a structure as shown in Fig. 4C. In this example, a second semiconductor material containing impurities of a second conduction-type different from the first one of the semiconductor substrate 200 is melted, and dropped directly or sprayed onto the uneven surface of the recessed substrate 208. This molten semiconductor material has substantially no wettability on the mask pattern(s), and will therefore, not remain substantially on the mask pattern(s).

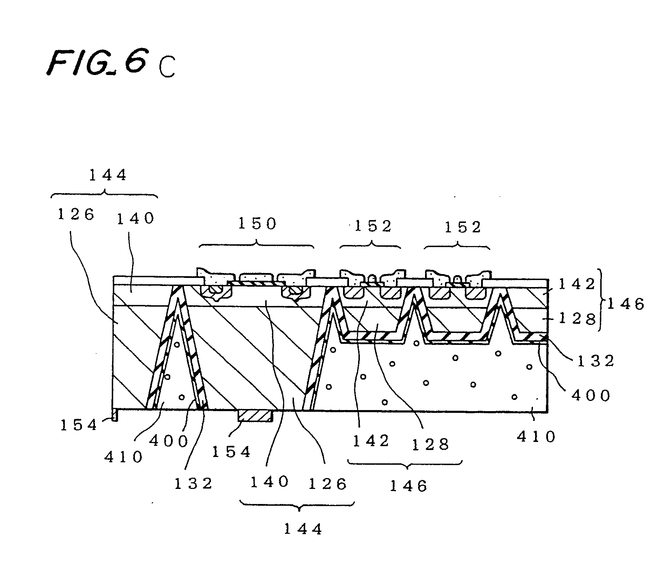

The technique of dropping the molten semiconductor material is disclosed in KOKAI TOKKYO KOHO No. 58-162035 and disclosed in the specifications of the Japanese KOKAI TOKKYO KOHO No. 2-161746. According to the disclosed techniques, the semiconductor substrate 208 of the first conductive type is placed on a rotating stage heated to approximately 1300 °C, and semiconductor material of the second conductive type melted at approximately 1440 °C is dropped onto the substrate 208. Fig. 7 is a sketch diagram schematically showing one example of an apparatus for carrying out a dropping technique of molten semiconductor material while using a spin method.

As shown in Fig. 7. the first conductive-type semiconductor substrate 208 is placed on a rotating stage 70, which rotates in the direction shown by an arrow with a mark A1, while heating both the rotating stage 70 and the semiconductor substrate 208 with heaters 72 arranged around the rotating stage.

A quartz funnel 74 is arranged above the semiconductor substrate 208, and a quartz crucible 76 is arranged above the quartz funnel 74. The quartz crucible 76 is filled with melting semiconductor material 78 containing the second conductive-type impurity. Heaters 80 arranged on around the quartz crucible 76 heat the quartz crucible 76 and keep the melting semiconductor material 78 in this crucible in a molten state.

The semiconductor material 78 melted in the quartz crucible 76 drops down from the quartz crucible 76 onto the semiconductor substrate 208 through the quartz funnel 74.

Because the semiconductor substrate 208 is rotated as the rotating stage 70 rotates, and is heated by the heaters 72, the molten semiconductor material 78 is coated on the semiconductor substrate 208 and fills the recess(es) 206.

In this process, as the molten semiconductor material 78 has poor wettability on the $SiO_2$ film (mask), the molten semiconductor material 78 dropped in the $SiO_2$ film 204 is immediately repelled, and accumulates only on the recesses 206. Therefore, semiconductor layers 210 are formed in the recesses 206 of the semiconductor substrate 208 (Fig. 4C).

Furthermore, because the recesses 206 have an exposed single crystal surface, the second semiconductor layers 210 also become single crystal regions.

The semiconductor layers 210 are formed on the semiconductor substrate 208, the principal surface of which is polished or ground, and smoothed. As a result, a semiconductor substrate having provided therein the semiconductor regions 212 as shown in Fig. 4D is obtained.

In this case, because the only area required for polishing the top surface of the structure shown in Fig. 4C is the small portions of the second semiconductor region projected above the recesses 206, the top surface is made flat quickly and easily as the $SiO_2$ film 204 acts to stop the polishing.

The $SiO_2$ film 204, which still remains on the substrate in the state shown in Fig. 4D, may be removed completely by using the grinding, polishing or etching technique.

In this second embodiment, the conduction type is different between the first conductive-type semiconductor substrate 200 or 208 and the second semiconductor regions 212. However, the method used in this embodiment can also be applied to cases in which the conductive-type is identical but the impurity concentration is different such, for example, as in $N^+$ and N or $P^+$ and P.

THIRD EMBODIMENT

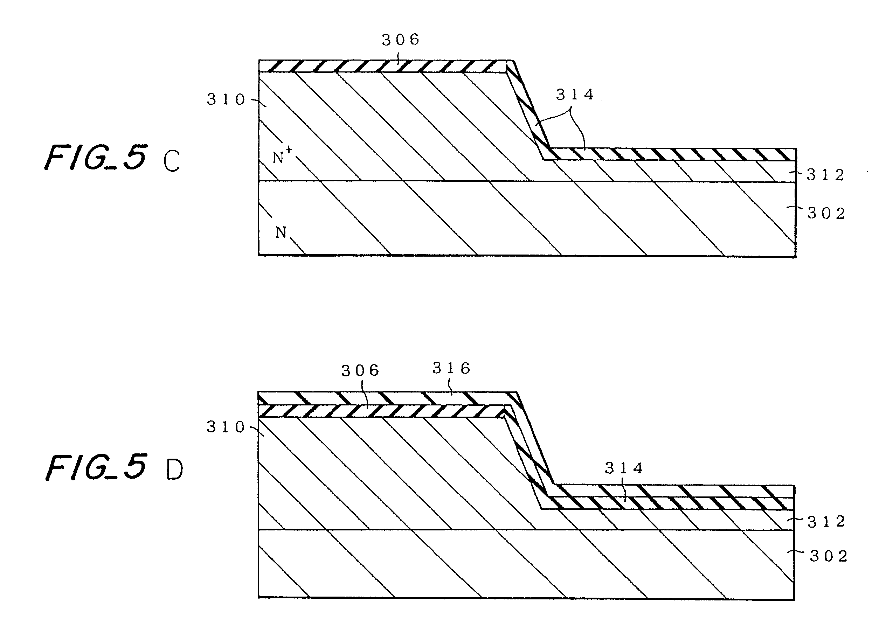

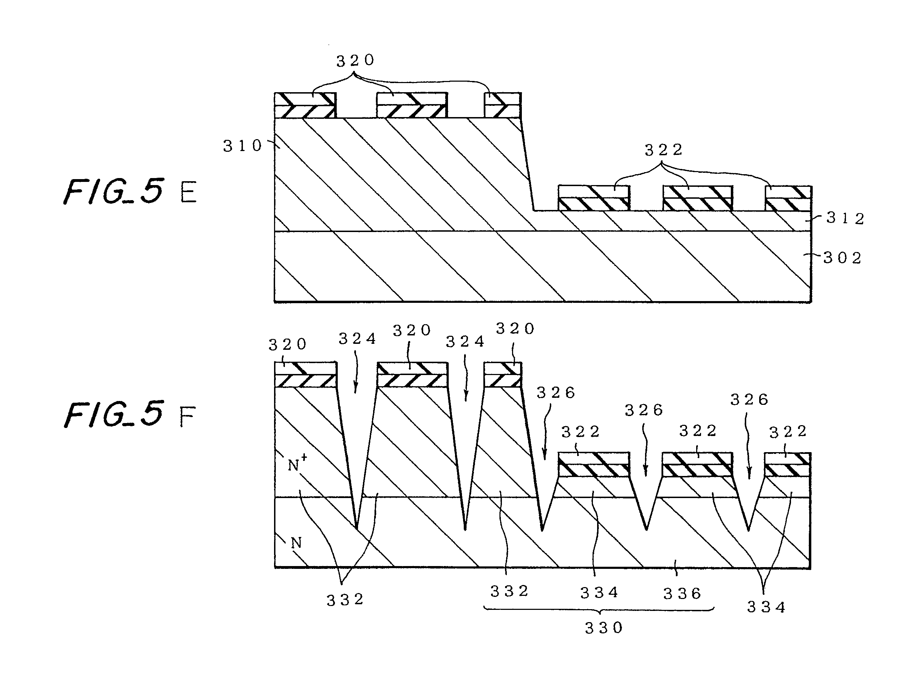

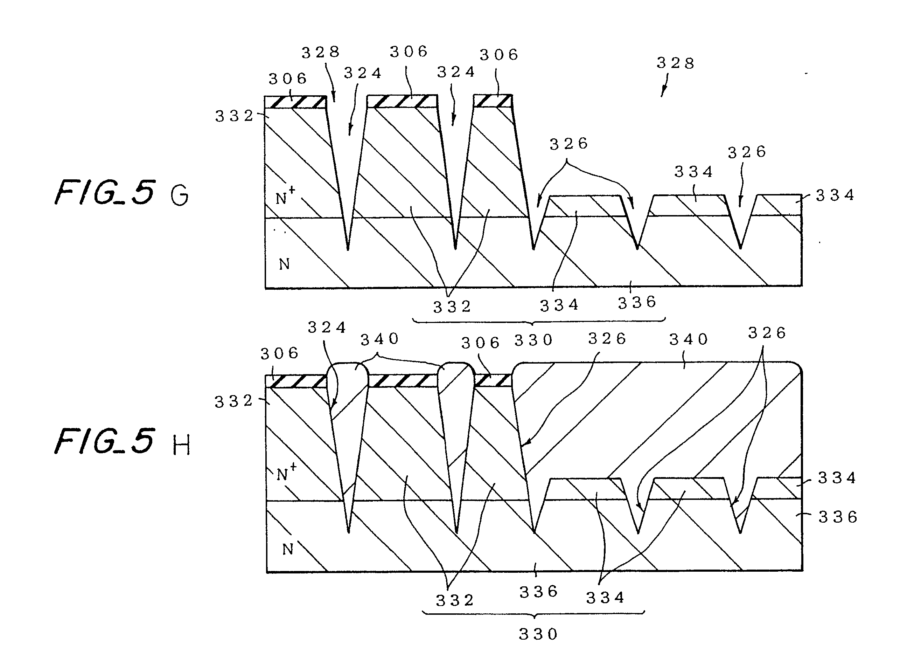

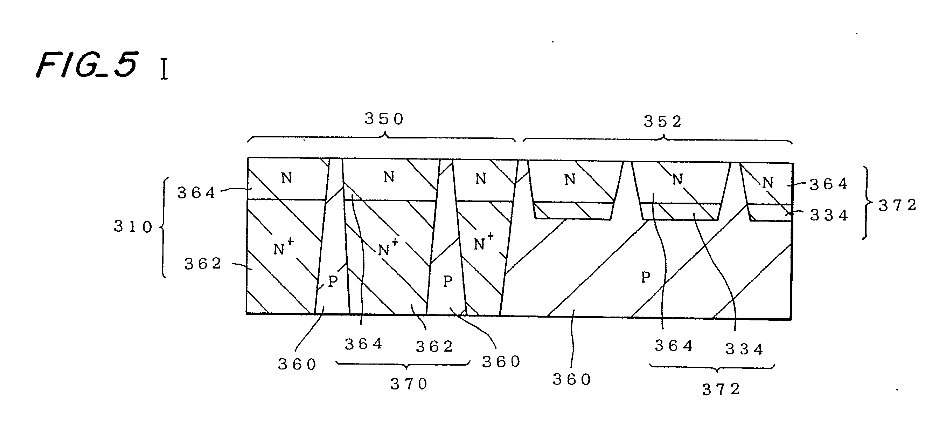

The third embodiment of the present invention will now be explained. Figs. 5A to 5I are diagrams schematically showing, in cross-section, structures formed in the respective steps of the process for explaining the third embodiment of the present invention.

This third example relates to a method for isolating multiple-output type SMART POWER DEVICES. First, as shown in Fig. 5A, an N-type epitaxial layer 302 with the desired thickness is formed on one of the principal surfaces of a semiconductor substrate, for example, an $N^+$ Si substrate 300 with the surface orientation of (100) thereby obtaining a semiconductor substrate body 304 (Fig. 5A). Next, using the same method as described referring to Fig. 3B, a thermal $SiO_2$ film with a thickness of at least 1 $\mu$m is formed on the other principal surface of the $N^+$ Si substrate 300.

Subsequently, in a manner similar to that of the first embodiment (see Fig. 3C), openings are formed on the $SiO_2$ film using photolithographic etching technology to obtain a first mask pattern 306 (Fig. 5B).

In this step, the N-type epitaxial layer 302 has its thickness of at least, approximately 100 $\mu$m.

Then, using the same method as described in the first embodiment, the exposed principal surface of the substrate 300 is subjected to an alkaline anisotropic etching treatment, to form a recess(es) or a concave portion(s) 308 in the $N^+$ Si substrate 300, while using the first mask pattern 306 as a mask.

At this time, in a manner similar to that described in the first embodiment (see Fig. 3D), the region of the $N^+$ Si substrate will not be completely removed, but partially be remained, and a structure as shown in Fig. 5B is thus obtained. The remaining or residual portion of the $N^+$ Si substrate 300 will remain at the bottom of the logic section after the SMART POWER DEVICES have been isolated, and will play a role in reducing the collector resistance. In Fig. 5B, the thick substrate portion or layer that remains as a result of the above first etching is shown by a reference numeral 310, and the thin remaining substrate portion or layer is also shown by a reference numeral 312.

Next, the second mask patterns 320 are formed on the thick substrate layer 310 using the first mask pattern 306. At the same time, third mask patterns 322 are formed on the thin substrate layer 312 (Fig. 5E).

For the purpose, first, an $SiO_2$ film 314 with a thickness of approximately 200 Å is formed on the exposed surfaces of the thin substrate layer 312 and the wall of the thick substrate portion 310 facing the recess 308 (Fig. 5B) by means of thermal oxidation or a CVD technique, thus obtaining a structure as shown in Fig. 5C. Subsequently, a silicon-nitride film 316 is formed with its thickness of approximately 1000 Å on the $SiO_2$ film serving as the first mask pattern 306 and the $SiO_2$ film 314 to thereby obtain a structure as shown in Fig. 5D.

Next, the desired resist pattern, which is not shown, is formed on the siilicon-nitride film 316 and then, using the pattern as a mask, the silicon-nitride film 316 and the $SiO_2$ films 304 and 314 beneath the silicon-nitride film are partially removed by a photolithographic etching technology to obtain a structure as shown in Fig. 5E. As a result of the photolithographic etching, the second mask patterns 320 and third patterns 322 are obtained as shown in Fig. 5E.

Then, exposed portions of the thick substrate layer 310 and thin substrate layer 312 are subjected to a second etching treatment from the side of the second and third mask patterns 320 and 322. This second alkaline anisotropic etching treatment is carried out until the respective tips of to be formed grooves reach the desired depth in the N-type epitaxial layer 302, thus forming deep grooves 324 and shallow grooves 326. In this embodiment, the grooves has V-shapes in cross-section. A structure having formed therein these grooves 324 and 326 is shown in Fig. 5F.

In this step, the V-shaped grooves 324 and 326 can be easily formed to different depths by selecting suitable values for the widths of the mask openings formed in the silicon-nitride film 316 and the $SiO_2$ film 306 and 314 therethrough. The remaining film portions are used as masks for etching treatment with the alkaline type etching solution.

In this example, each of the grooves 324 and 326 has an identical depth from the interface between the first semiconductor substrate 300 and the epitaxial layer 302 (see Fig. 5F), which is similar to that of the first example (see Fig. 3H).

In Fig. 5F, a portion(s) of the semiconductor substrate body that is remained as a result of the second etching is shown by a reference numeral 330. A semiconductor substrate body with grooves are also called as a grooved semiconductor body 330. Remaining island-like regions of the thick and thin substrate layers are shown by numerals 332 and 334, respectively, and an epitaxial layer having formed therein the grooves is shown by a reference numeral 336.

Next, the third mask patterns 322 used in the second etching treatment are removed. To attain this, an etching treatment is used to remove the portions of the silicon-nitride film 316 and the portions of the $SiO_2$ films 306 and 314 that were used as the masks. In this case, first, the silicon-nitride film portions serving as the parts of the first and second mask patterns are removed by the phosphoric acid. Subsequently, the remaining $SiO_2$ film portions of the first and second mask patterns are removed by the aqueous hydrofluoric acid. After this etching treatment, whole or part of the thermal $SiO_2$ material used as the first mask pattern 306 is partially remained in its thickness direction because the thickness of the portion 306 is sufficiently thicker than that of the $SiO_2$ film used as the second mask pattern. As a result, such a structure having a recess(es) 328 as shown in Fig. 5G, is obtained.

Next, as explained in the second embodiment, the recess(es) or concave portion(s) including the grooves on the structure shown in Fig. 5G are filled with a semiconductor material suitable for forming semiconductor layers 340, thereby obtaining a structure as shown in Fig. 5H. In this example, molten Si material containing P-type impurity is dropped directly or sprayed on the structure so as to fill the V-shaped grooves 324 and 326 with the material, thereby forming in the grooves the P-type impurity semiconductor layers 340. Thus, a structure as shown in Fig. 5H is obtained. At this time, because the molten Si has poor wettability on $SiO_2$, the P-type impurity semiconductor regions 340 are not formed on the surface of the thermal $SiO_2$ film 306.

Subsequently, the structure shown in Fig. 5H is planarized by polishing or grinding the surface thereof on the side of the semiconductor layers 340, thus forming a planarized or flat surface thereof. Then, the N-type epitaxial region 336 is planarized by polishing from its exposed principal surface down to the bottom of the V-shaped grooves 324 and 326, thus making a polished surface of the N-type epitaxial region flat and obtaining a structure as shown in Fig. 5I. In Fig. 5I, while showing the structure turned upside down from the state shown in Fig. 5H, the semiconductor regions of the P-type impurity that remained as a result of the polishing are shown by a reference numeral 360, the remaining $N^+$ type island-like regions by reference numeral 364.

A semiconductor substrate is thus obtained in which a thick isolated island(s) 370 separated from each other by the P-type impurity semiconductor regions 360 and a thin isolated island(s) 372 similarly separated from each other and from the thick isolated island(s) 370 by these regions 360 are formed, respectively. Power output section 350 will be formed on these thick isolated islands 370, and logic section 352 will be formed on these thin isolated islands 372. Therefore, this semiconductor substrate is suitable for forming SMART POWER devices with multiple outputs.

FOURTH EMBODIMENT

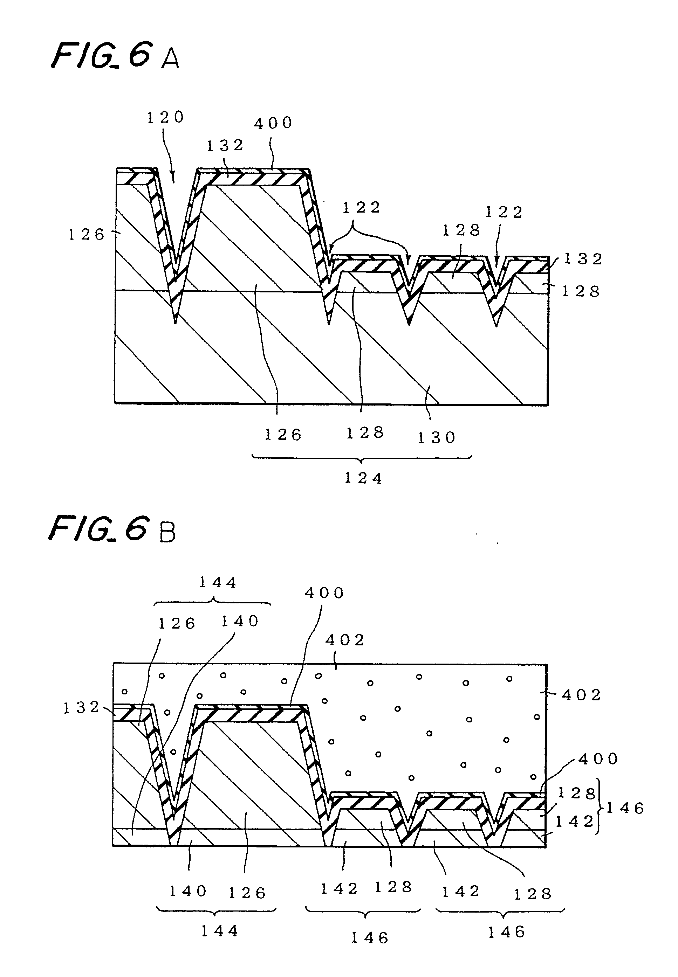

The fourth embodiment is a variation of the first embodiment. This example is explained with reference to Figs. 6A to 6C. In a manner similar to that explained in the first example, a structure shown in Fig. 3J is obtained starting from the structure shown in Fig. 3A. In Figs. 6A to 6C, the constituents identical with those in Figs. 3A to 3N are shown by the same reference numerals.

Next, in this fourth embodiment, semiconductor layers are formed by dropping molten semiconductor material in the same manner used in the second and third embodiment. An $SiO_2$ film with poor wettability on the molten semiconductor material is often used for the isolation film disposed on the structure shown in Fig. 3J. Therefore, an insulation film that has good wettability on the molten semiconductor material, such as a silicon-nitride film 400, is formed as a thin intermediate layer with a thickness of approximately several thousands Å on the isolation film 132 using a suitable method such as the CVD method. A structure thus obtained is shown in Fig. 6A. A polysilicon film of an approximately 10 $\mu$m thickness may be used instead of a silicon-nitride film.

Using a dropping method explained in the second embodiment through a spin or spray technique, on the intermediate layer 400 in the structure shown in Fig. 6A, the molten semiconductor material 402 containing or not containing impurities, such as molten silicon is dropped and then flown into at least the recess of the grooved structure to obtain a structure as shown in Fig. 6B.

Thereafter, the second semiconductor substrate 130 is polished or ground on its exposed side to form deep isolated-islands 144 and shallow isolated-islands 146 in a manner similar to that described in the first embodiment with reference to Fig. 3L.

Then, after the power devices 150 and logical devices 152 are formed respectively on the regions 140 and 142, respectively, that remain on the second semiconductor substrate, the substrate is polished on the side of the semiconductor layers 402 to form a flat or planarized surface thereof. After that, the electrode 154, and a structure as shown in Fig. 6C is thus obtained. Fig. 6C shows the structure turned upside down from the state shown in Fig. 6B. These steps may be carried out in the same manner as that used for forming the structure shown in Figs. 3M and 3N. However, in Fig. 6C, the semiconductor layers that remained after polishing are shown by a reference numeral 410.

It is clear to those skilled in the art that the present invention is not limited to the above-mentioned example, and can be modified for use in a wide range of applications without departing from scope and spirit of the present invention.

For instance, the shape in cross-section of the grooves disposed on the substrate do not have to be V-shaped, and can be U-shaped, or some other shape, according to the crystal orientation of the substrate surface.

In addition, while a substrate with a (100) orientation is used in the above-mentioned examples, a silicon substrate having a (111) orientation may be used instead, and so etching is carried out by using nitric acid-hydrofluoric acid type solution instead of using alkaline anisotropic etching.

Furthermore, the explanation is made using molten silicon as to form the semiconductor layers or regions, but a Si and Ge mixture molten semiconductor material may be used instead.

Further, the numerical conditions referred to in the above embodiment are only the preferred conditions, and the present invention should not be limited to these numerical condition as such.

Thus, the various production process conditions may vary according to the designing.

As can be seen from the above examples, according to the present invention, a semiconductor substrate with separated or isolated island-like semiconductor regions can be formed. According to the first and fourth embodiments, because the parts serving as or forming the active regions in isolated islands are so arranged that they are formed by attaching the first semiconductor substrate to the second one, with a bonding technique, auto-doping from the first semiconductor substrate will not generate. Thus, a semiconductor substrate with high resistivity and greater thickness can be formed easily.

In addition, the N-type substrate can be formed faster and at a lower cost by using the epitaxial growth technology, and the second semiconductor substrate can be easily made thicker by stacking it on the first semiconductor substrate. These advantages allow the substrate to maintain a sufficiently high mechanical strength, and also allow the polycrystalline silicon to grow under a usual CVD process without using special technique, such as interposing a glass layer, as required by conventional methods to form supporting layers for dielectric isolation substrates.

Furthermore, according to the second embodiment, the semiconductor substrate of a first conduction type is etched at a predetermined region(s) to form a recess(es) or a concanve portion(s), which are filled with a molten semiconductor material of a conduction type different from that of the semiconductor substrate, or of the same conduction type as that thereof but different in its impurity concentration therefrom. Therefore, in this embodiment, there required additional steps such as etching step, dropping step of molten semiconductor silicon, and polishing step. However, according to the second embodiment, the production process including these three steps is completed in much shorter time than the process including a long diffusion step that is used conventionally. As a result of this, the diffusion of the impurity in the lateral direction is greatly reduced, and hence a non-effective area(s) is also greatly reduced. Therefore, improved integration density can be expected.

Moreover, according to the third embodiment, after epitaxial grown regions of the first conduction type are formed on one of the principal surfaces of the semiconductor substrate of the conduction type, a recess(es) are formed in the other principal surface. After that, an insulation film is formed and then patterned to form V-shaped grooves. In the grooves impurity regions of the second conduction type which differ from the semiconductor substrate are formed. Then, the epitaxial regions are polished to expose the impurity regions of the V-shaped grooves. In the impurity regions, power output parts and logic parts are formed, thus making it possible to isolate multiple type output SMART POWER devices. Therefore, the number of epitaxial growth step is reduced as compared with the conventional method, and, also, the isolation diffusion time between the epitaxial regions and semiconductor substrate can be shortened as compared with the conventional method.

**Claims**

1. A process for producing a semiconductor substrate comprising the steps of:

(a) forming a semiconductor substrate body (104) by attaching a first semiconductor substrate (100) to a second semiconductor substrate (102);

(b) forming the first mask pattern(s) (108) on the principal surface of the first semiconductor substrate;

(c) carrying out a first etching treatment of an exposed principal surface region(s) of the first semiconductor substrate from the side of the first mask pattern(s) down to a depth reaching part in a thickness direction of the first semiconductor substrate;

(d) removing the first mask pattern(s);

(e) forming the second mask pattern(s) (116) on exposed surface of each of thick and thin substrate layers (110, 112) which are regions of the first semiconductor substrate remained after the first etching treatment;

(f) carrying out a second etching treatment of exposed regions of the thick and thin substrate layers, from the side of the second mask pattern(s) to form grooves (120, 122) reaching inside the second semiconductor substrate, the grooves having their bottoms at an identical depth from an attaching interface of the first and second semiconductor substrates;

(g) forming, after the removal of the second mask pattern, an isolation film (132) on the entire surface of the grooved side of the semiconductor substrate body (124);

(h) forming a semiconductor layer (136; 402) by filling a recess(es) (134) of a structure obtained after the formation of the isolation film with semiconductor material;

(i) polishing the second semiconductor substrate (102) from the exposed principal surface thereof to a depth reaching the bottom of the grooves; and

(j) polishing a structure obtained after the formation of the semiconductor layer(s) from the surface side thereof to a depth reaching midway in the thickness direction of the thick substrate layer(s), but not reaching the isolation film on the thin substrate layer(s), thereby obtaining deep and shallow isolated-islands (144, 146) as semiconductor regions.

2. A process for producing a semiconductor substrate as claimed in claim 1, wherein the first and second semiconductor substrate are made of silicon substrates, respectively.

3. A process for producing a semiconductor substrate as claimed in claim 1, wherein the first and second semiconductor substrates are of the same conduction type, and the resistivity of the second semiconductor substrate is made higher than that of the first semiconductor substrate.

4. A process for producing a semiconductor substrate as claimed in claim 1, wherein the first and second semiconductor substrates are attached together directly.

5. A process for producing a semiconductor substrate as claimed in claim 2, wherein the first and second semiconductor substrates are attached together directly after having undergone a hydrophilic treatment thereof.

6. A process for producing a semiconductor substrate as claimed in claim 1, wherein the first and second etching treatment are carried out by using respective alkaline type of etching solution which may be the same or different.

7. A process for producing a semiconductor substrate as claimed in claim 1, wherein the first and second etchings are carried out by using a nitric acid-hydrofluoric acid type of etching solution which may be the same or different.

8. A process for producing a semiconductor substrate as claimed in claim 1, wherein the first and second mask patterns are formed by the substeps of:
   (i) forming an insulation film (106, 114) by using thermal oxidation or CVD method, and
   (ii) patterning the insulation film by using a photolithographic etching technology.

9. A process for producing a semiconductor substrate as claimed in claim 1, wherein the semiconductor layer(s) is formed with polysilicon grown directly on the isolation film by using a method of reduction with hydrogen.

10. A process for producing a semiconductor substrate as claimed in claim 1, wherein the semiconductor layer (402) is formed on the isolation film (132) with thin intermediate layers (400) interposed therebetween, the formation of the semiconductor layer being carried out by using a technique of dropping molten semiconductor material onto the semiconductor substrate.

11. A process for producing a semiconductor substrate as claimed in claim 10, wherein the thin intermediate layers are formed with material having good wettability on the molten semiconductor material by using a CVD method.

12. A process for producing a semiconductor substrate comprising the steps of:
   (a) forming a semiconductor substrate body (304) by means of growing an epitaxial layer (302) on one of the principal surfaces of a semiconductor substrate (300);
   (b) forming the first mask pattern(s) (306) on the other principal surface of the semiconductor substrate:
   (c) carrying out a first etching treatment of an exposed region(s) of the other principal surface of the semiconductor substrate from the side of the first mask pattern(s) down to a depth reaching part of the thickness of the semiconductor substrate;
   (d) forming the second mask pattern(s) (320) on a thick semiconductor layer(s) (310) by utilizing the first mask pattern(s) and the third mask pattern(s) (322) thinner than the second mask pattern(s) on a thin substrate layer(s) (312), the thick and thin substrate layers being regions of the semiconductor substrate remained after the first etching treatment;
   (e) carrying out a second etching treatment of exposed regions of the thick and thin substrate layers (310, 312) from the side of the second and third mask patterns to form grooves (324, 326) reaching inside the epitaxial layer, the grooves having their bottoms at an identical depth from the interface of the semiconductor substrate and the epitaxial layer;
   (f) removing the third mask pattern(s);
   (g) forming, after the removal of the third mask pattern(s), a semiconductor layer(s) (340) having a flat surface by filling a recess(es) (328) of a structure obtained after removal of the third mask pattern(s) with molten semiconductor material having poor wettability on the first mask pattern(s) and containing impurity;
   (h) polishing the epitaxial layer from exposed principal surface thereof to a depth reaching the bottom of the grooves; and
   (i) polishing the semiconductor layer(s) from the surface side thereof to a depth reaching midway in the thickness direction of the thick substrate layer(s), but not reaching the thin substrate layer(s), to thereby obtain a semiconductor region(s) (360) with residual part of the semiconductor layer(s) (340).

13. A process for producing a semiconductor substrate as claimed in claim 12, wherein the semiconductor substrate and the epitaxial layer consist of silicon material, respectively.

14. A process for producing a semiconductor substrate as claimed in claim 12, wherein the first mask pattern (306) is formed by the substeps of:
   (i) forming a thermal oxide film on the other principal surface of the semiconductor substrate; and
   (ii) patterning the thermal oxide film by using a photolithographic etching technology.

15. A process for producing a semiconductor substrate as claimed in claim 12, wherein the semiconductor substrate and the epitaxial layer are of the same conduction type, and the resistivity of the epitaxial layer is made higher than that of the semiconductor substrate.

16. A process for producing a semiconductor substrate as claimed in claim 12, wherein the first and second etching treatments are carried out by using respective alkaline type of etching solutions which may be the same or different.

17. A process for producing a semiconductor substrate as claimed in claim 12, wherein the first and second etching operations are carried out by using respective nitric acid-hydrofluoric acid type etching solutions which may be the same or different.

18. A process for producing a semiconductor substrate as claimed in claim 12, wherein the second and third mask patterns are formed by the substeps of:

(i) forming a lower layer film(s) (314) thinner than the first mask pattern(s) (306) on the structure obtained after the step (C) at the exposed surface of the remaining portion(s) (310, 312) of the semiconductor substrate by using a material with poor wettability on the molten semiconductor material;

(ii) forming an upper layer film (316) on the first mask pattern(s) (306) and the lower film(s) (314) by using a material with good wettability to the molten semiconductor material; and

(iii) patterning a first layer consisting of the first mask pattern and the upper layer film, and a second layer consisting of the lower layer film(s) and the upper layer film by using a photolithographic etching technology.

19. A process for producing a semiconductor substrate as claimed in claim 12, wherein the third mask pattern (322) is removed by etching treatment, and, at the same time, the second mask pattern (320) is partially removed so as to leave whole or part of material forming the first mask pattern.

20. A process for producing a semiconductor substrate as claimed in claim 12, wherein the semiconductor layer(s) are formed by using a direct dropping method of the molten semiconductor material or using a spray-dropping method thereof.

21. A process for producing a semiconductor substrate comprising the steps of:

(a) forming a mask pattern(s) (204) consisting of insulation film(s) on one of the principal surfaces of a semiconductor substrate (200);

(b) forming a recess(es) (206) by carrying out an etching treatment of principal surface portions of the semiconductor substrate uncovered with the mask pattern(s);

(c) forming a semiconductor layer(s) (210) in the recess(es) by dropping molten semiconductor material containing impurity and with poor wettability to the mask pattern(s) onto the surface, on the side of the mask pattern(s), of a structure obtained in the step (b); and

(d) polishing a structure obtained in the step (c) from its surface on the side of semiconductor layer(s) so as to form a flat surface consisting of the surface of the insulation film(s) and that of the semiconductor layer(s) to thereby obtain a semiconductor region(s) (212) with residual part of the semiconductor layer(s).

22. A process for producing a semiconductor substrate as claimed in claim 21, wherein the semiconductor substrate is composed of a silicon single crystalline substrate, and the insulation film is formed as an $SiO_2$ film by thermally oxidizing the silicon single crystalline substrate.

23. A process for producing a semiconductor substrate as claimed in claim 21, wherein the etching treatment is carried out by using an alkaline type of etching solution.

24. A process for producing a semiconductor substrate as claimed in claim 21, wherein the etching treatment is carried out by using a nitric acid-hydrofluoric acid type of etching solution.

25. A process for producing a semiconductor substrate as claimed in claim 21, wherein the semiconductor substrate and the semiconductor region(s) are of the same conduction type, while being different in the impurity concentration therebetween.

26. A process for producing a semiconductor substrate as claimed in claim 21, wherein the semiconductor substrate and the semiconductor region(s) are of different conduction types.

*FIG_I* A

*FIG_I* B

*FIG_I* C

## *FIG.2* A

## *FIG.2* B

## *FIG.2* C

## *FIG.2* D

26    36

40

38

N⁺

N

28

A ——————— A

22

## *FIG.2* E

46    48

22

42

N⁺

44

36

B ——————— B

38

40

42    44

## FIG_2 F

## FIG_7

*FIG_3* A

*FIG_3* I

*FIG_3* L

*FIG_3* A

*FIG_3* B

# FIG_3 C

108    100a

100
102    } 104

# FIG_3 D

108
110
112
102

## FIG. 3 E

## FIG. 3 F

## *FIG. 3* G

116   116

110

116   116

112

102

## *FIG. 3* H

116   120   116   122

122   122

126   116   116   116

128

126   128   130

124

*FIG_3* I

*FIG_3* J

24

# EP 0 445 649 A2

## FIG. 3 K

## FIG. 3 L

25

# *FIG_3* M

144 144

140 126 126 140 136

132

128 146

142

150 152 152

# *FIG_3* N

144 146

126 140 150 152 152 142 128

132

148

154

132 126 140 142 128 142 128

148 154

144 146 146

## FIG_4 A

204   202   204   202   204

200

## FIG_4 B

204   206   204   206   204

208

*FIG_4* C

204    210    206    204    206    210    204

208

*FIG_4* D

204    206    212    204    206    212    204

208

EP 0 445 649 A2

*FIG_5* A

N⁺ ──300
     ⎫
     ⎬ 304
     ⎭
N ──302

*FIG_5* B

306
310 ── N⁺
308
312
N ── 302

EP 0 445 649 A2

## FIG_5 C

306

310

N⁺

N

314

312

302

## FIG_5 D

306     316

310

314

312

302

FIG_5 E

FIG_5 F

EP 0 445 649 A2

FIG_5 G

FIG_5 H

EP 0 445 649 A2

## FIG_5 I

*FIG.6* A

*FIG.6* B

# FIG. 6 C